# EUROPEAN PATENT APPLICATION

(11) **EP 4 538 919 A1**
(43) Date of publication of application: **16.04.2025**
(21) Application number: 24206275.0
(22) Date of filing: 11.10.2024
(51) Int. Cl.: G06F 30/12, G06F 30/17, G06Q 10/0875

(54) **METHODS AND SYSTEMS FOR STORING LEGACY COMPUTER-BASED MODELS**

(30) Priority: 12.10.2023 IN 202341068717; 21.05.2024 US 202418670326
(71) Applicant: Dassault Systemes SolidWorks Corporation, Waltham, MA 02451-1223 (US)
(72) Inventor: BIRKETT-SMITH, Nicholas Constantine, Waltham, 02451 (US); PANDIT, Pushpak Dhanajay, 411051 Pune (IN); MANE, Vikas Uttam, 411034 Pune (IN)
(74) Representative: Bandpay & Greuter

(57) **Abstract**

Embodiments store legacy computer-based models in product lifecycle management (PLM) platforms. Using a legacy computer-based model which is comprised of one or more configurations of one or more elements representing a real-world object, embodiments define a data handling rule which indicates a type for at least one element of a given configuration. The type defines logic for processing the at least one element as a function of characteristics of the at least one element. The given configuration is processed in accordance with the defined data handling rule and the defined logic. Processing the configuration includes storing the at least one element of the given configuration in memory associated with the PLM platform as a unique product or a representation of a unique product.

## Description

### BACKGROUND

A number of existing product and simulation systems are offered on the market for the design and simulation of objects, e.g., components, parts, and assemblies of components or parts, among other examples. Such systems typically employ computer-aided design (CAD) and/or computer-aided engineering (CAE) programs. These systems allow a user to construct, manipulate, and simulate complex three-dimensional (3D) models of objects or assemblies of objects, e.g., real-world objects. CAD and CAE systems, thus, provide a representation of modeled objects using edges, lines, faces, polygons, or closed volumes. Lines, edges, faces, polygons, and closed volumes may be represented in various manners, e.g., with non-uniform rational basis-splines (NURBS).

CAD systems manage parts or assemblies of parts of modeled objects, which are mainly specifications of geometry. In particular, CAD files contain specifications, from which geometry is generated. From geometry, a representation is generated. Specifications, geometries, and representations may be stored in a single CAD file or multiple CAD files. CAD systems include graphic tools for representing the modeled objects to designers; these tools are dedicated to the display of complex objects. For example, an assembly may contain thousands of parts. A CAD system can be used to manage models of objects, which are stored in electronic files.

CAD and CAE systems use computer-based models to represent objects. A computer-based model may be programmed in such a way that the model has the properties (e.g., physical, material, or other physics based) of the underlying real-world object or objects that the model represents. Moreover, computer-based models may be used to perform simulations of the real-word objects/environments that the models represent.

Existing computer-based modeling software systems, such as SolidWorks^{®}, have offered the concept of "configurations" for over 20 years. Configurations are a feature in modeling software programs that let users create and manage multiple variations of a part or assembly within a single file. Users can vary dimensions, feature-suppression, custom properties, and other parameters across different configurations.

### SUMMARY

As noted above, the concept/feature of "configurations" has been available in computer-based modeling software for over 20 years. As such, there are a plethora of legacy computer-based models, e.g., CAD models, from legacy software programs that include configurations that would be beneficial to be used in modem software programs. However, modem computer-based modeling programs/platforms, such as product lifecycle management (PLM) platforms, are unable to handle the configuration features of these legacy computer-based models. Embodiments provide such functionality.

Embodiments provide the ability to define rules for CAD file configurations to either a PLM physical product, or a representation of a physical product. In embodiments, users can define different rules which will assign a different "sub-type" for parts and assemblies, using file-level criteria to identify the sub-types.

An example embodiment is directed to a computer-implemented method for storing a legacy computer-based model in a PLM platform. The method begins by a processor, obtaining, in memory of the processor, a legacy computer-based model, wherein the legacy computer-based model includes one or more configurations of one or more elements representing a real-world object. To continue, for a given configuration, the method defines a data-handling rule wherein the defined data-handling rule indicates a type for at least one element of the given configuration, and the type defines logic for processing the at least one element as a function of characteristics of the at least one element. In turn, the given configuration is processed in accordance with the defined data-handling rule and the defined logic. Processing the given configuration includes storing the at least one element of the given configuration in memory associated with the PLM platform as a unique product or a representation of a unique product.

In an embodiment, defining the data-handling rule includes receiving, from a user, an indication of the type for the at least one element of the given configuration. In another embodiment, defining the data-handling rule includes receiving, from a user, an indication of the logic for processing the at least one element, wherein the indication of the logic dictates, based on the characteristics, if the at least one element is stored as a unique product or a representation of a unique product.

In another embodiment, processing the given configuration in accordance with the defined data-handling rule and the defined logic includes, for the at least one element of the given configuration, identifying the type for the at least one element based on the defined data-handling rule, and based on the identified type, determining the defined logic for processing the at least one element as a function of characteristics. Such an embodiment identifies given characteristics of the at least one element and, based on the determined defined logic and the identified given characteristics, stores the at least one element in the memory associated with the PLM platform as a unique product or a representation of a unique product.

According to an embodiment, the one or more elements representing the real-world object include at least one individual component or an assembly of components of the one or more configurations.

In another embodiment, processing the given configuration in accordance with the defined data-handling rule and the defined logic includes identifying a given element of the given configuration, wherein the defined data-handling rule, and the defined logic does not indicate whether the given element should be stored as a unique product or a representation of a unique product. Responsive to identifying the given element, such an embodiment stores the given element as a unique product or a representation of a unique product in accordance with a default data-handling rule. Further, embodiments may also utilize a contingency provision for configurations which are not categorized by any rule.

In another embodiment, at least one configuration of the one or more configurations is one of a defeature configuration or a graphical representation configuration e.g., a speedpak configuration. In such an embodiment, a parent configuration of the at least one configuration is identified and an element of the at least one configuration is stored in the memory as a representation of a unique product corresponding to the identified parent configuration.

Another example embodiment is directed to a system for storing a legacy computer-based model, e.g., in a PLM platform. The system includes a processor and a memory with computer code instructions stored thereon. The processor and the memory, with the computer code instructions, are configured to cause the system to implement any embodiments or combination of embodiments described herein.

Yet another embodiment is directed to a cloud computing implementation for storing legacy computer-based models. Such an embodiment is directed to a computer program product executed by a served in communication across a network with one or more clients. The computer program product comprises a computer readable medium with program instructions which, when executed by a processor, causes the processor to implement any embodiments or combination of embodiments described herein.

### BRIEF DESCRIPTION OF THE DRAWINGS

The foregoing will be apparent from the following more particular description of example embodiments, as illustrated in the accompanying drawings in which like reference characters refer to the same parts throughout the different views. The drawings are not necessarily to scale, emphasis instead being placed upon illustrating embodiments.
FIG. 1 is a flowchart illustrating a method of storing a legacy computer-based model according to an embodiment.
FIG. 2 is flow diagram of a computer-implemented method for storing a legacy computer-based model in a PLM platform, according to an embodiment.
FIGs. 3A- 3C depict example graphical user interfaces (GUIs) that may be utilized in embodiments.
FIG. 4 is a simplified block diagram of a computer system for storing a legacy computer-based model according to an embodiment.
FIG. 5 is a simplified block diagram of a computer network environment in which embodiments may be implemented.

### DETAILED DESCRIPTION

A description of example embodiments follows.

Computer-based modeling software, e.g., CAD software program SolidWorks^{®}, offers configuration functionality. It is noted that while SolidWorks^{®} may be referenced herein, embodiments are not limited to use in SolidWorks^{®} and, instead, embodiments can be implemented and utilized in any software program that offers configuration functionality.

There are three main use-cases for configurations. The first use case, Use Case One (UC1), is modeling families of parts or assemblies. For example, each configuration is a unique part within a unique part number. A typical example of this would be different sizes of a bolt. The second use case, Use Case Two (UC2), is representing different states (representations) of the same part or assembly. For example, this may be an open / closed door on a cabinet, a spring at different compressions, or a fully detailed and simplified model of a complex part. In this example, the simplified model may be used in downstream processes to improve software performance. The third main use case, Use Case Three (UC3), is representing parts or assemblies before and after a process such as welding or machining.

When saving CAD files to various software products, e.g., a product lifecycle management (PLM) system such as the 3DEXPERIENCE^{®} Platform, the handling of configurations should be considered. There are different existing approaches for handling configurations. One approach is that every configuration becomes a unique physical product with a unique part number. This aligns with intent behind UC1, however, treating every configuration as a unique physical product with a unique part number creates unwanted physical products where configurations have been used for the purposes described in UC2 or UC3. This occurs at the time the data is saved to, for example, the 3DEXPERIENCE^{®} Platform PLM system.

Another existing approach is using predefined logic for mapping some configurations to physical products (UC1), and other configurations to representations of a physical product (UC2 and UC3). With this approach, representations remain in the CAD file as configurations, however, the representations are not managed as unique objects by the PLM system. In other words, the CAD software will remain aware of the representations as configurations, but the PLM software will have no awareness of the configurations. The logic for mapping configurations analyzes certain characteristics of the CAD (e.g., a legacy computer-based model) file, such as configuration settings, to determine whether each configuration should be mapped to either a physical product (having a unique part number) or representation of a physical product (being associated with an existing part number). This mapping can occur either as the legacy model is opened from disk; or, after opening responsive to a user invoking a command to update the model. In both cases the user has explicitly chosen to perform the mapping operation using a command (in the case of 3DEXPEREINCE^{®}, for example, "Update for 3DEXPERIENCE^{®} Compatibility"). Note the changes are not committed until the model is saved to the PLM system (3DEXPERIENCE^{®} Platform).

In legacy systems, a user must decide between these two existing approaches when saving data to the platform. However, the user may have a mix of data-patterns and configuration use-cases in their organization, and thus have a requirement to define the logic used in a more precise and specific way. In legacy systems, this is not possible. In addition, in legacy systems, it is not possible to customize the logic used for saving CAD data to a PLM system, in order to ensure that the design intent for CAD configurations can be accurately reflected in the destination PLM system. In organizations who have used CAD configurations for multiple purposes and may have complex data patterns, there is no combination of options which can generate the desired results for all data patterns.

Embodiments solve this problem. Embodiments provide the ability to define rules for mapping CAD file configurations to either a PLM physical product, or a representation of a physical product. Embodiments allow users to define different rules which assign a different "sub-type" for their parts and assemblies, using file-level criteria to identify the sub-types (e.g., file properties such as part number, file name, etc.).

According to an embodiment, for each sub-type of file, logic can be defined for mapping configurations to PLM physical products or representations as either a single physical product, or multiple physical products. For a single physical product, the user can define which configuration will become the single physical product using configuration level criteria. Other configurations can be representations of the designated single physical product. For multiple physical products, i.e., a rule that pertains to multiple different physical products, configuration-level criteria can be used to identify the mapping (e.g., configuration properties, configuration names, configuration settings). Multiple configurations can become physical products, while retaining the ability for some configurations to be designated as representations of a parent physical product.

For example, for a mapping of a single physical product, an exemplary bolt that is 2" long and has complete detailed information associated therewith can be defined as the configuration which is a single physical product, and a representation may be the same 2" bolt without full details of threads of the bolt. In this example, the use of a representation (the 2" bolt without the thread details) requires less computing power and memory, and therefore improves performance of the modeling software. This simplified bolt configuration is a representation of the fully detailed parent, physical product configuration of the 2" bolt. When using mapping rules for multiple physical products, the user may be able to designate, for example, all part numbers beginning with "98" or "99" are to be treated as physical products, and all others are representations.

Embodiments offer improved accuracy in mapping the intent behind CAD configuration usage to the PLM system. This reduces the amount of unwanted physical products in the PLM system, which can have downstream benefits to database size and performance.

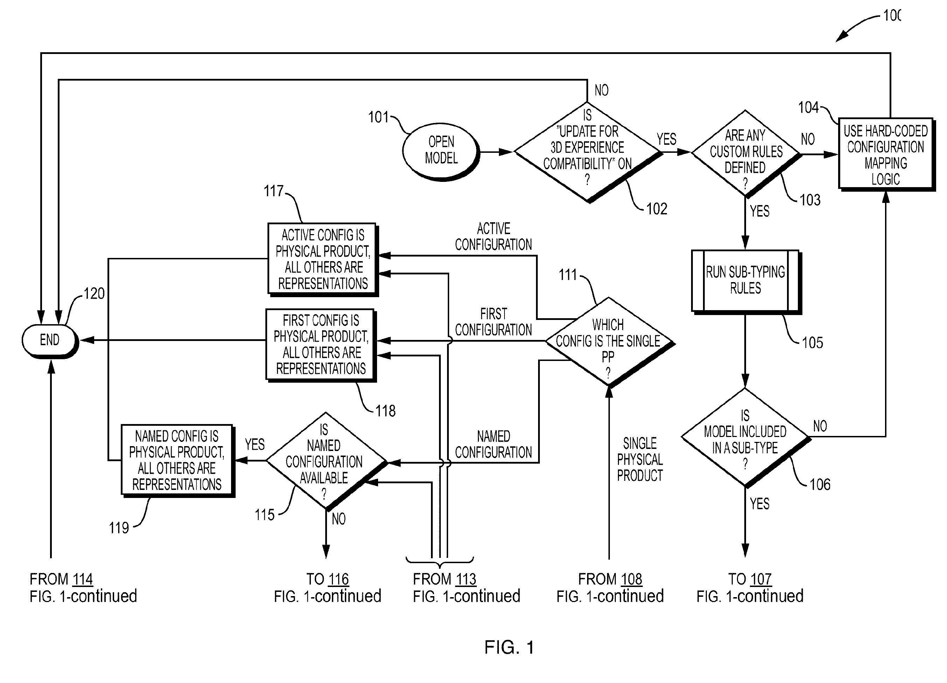

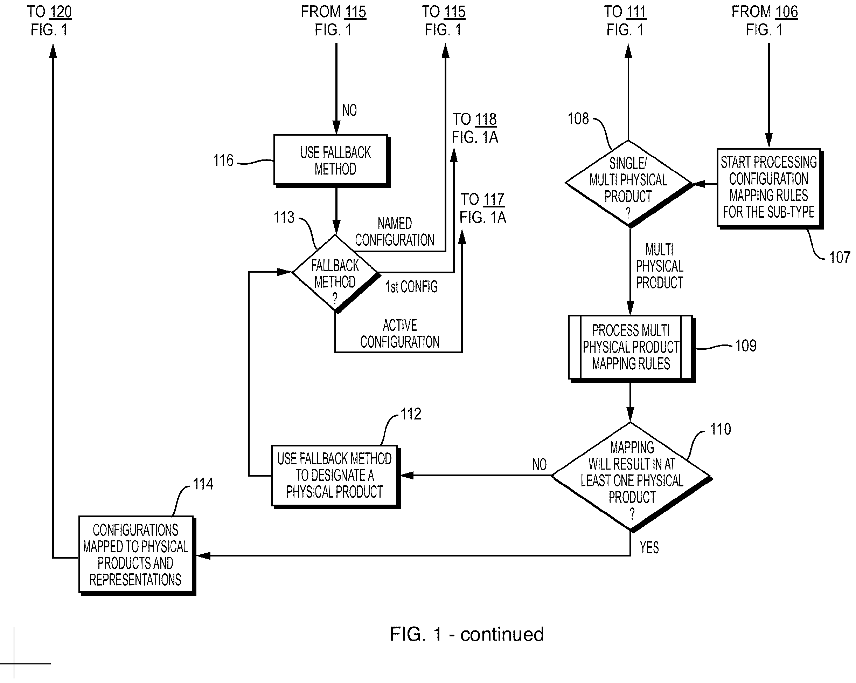

FIG. 1 is a flow chart diagram illustrating a method embodiment 100 for storing a legacy computer-based model in a PLM platform. The method 100 starts at step 101 responsive to a user opening a CAD model and, then, progresses to step 102 where it is determined if "Update for 3DEXPERIENCE Compatibility" is on. In other words, step 102 checks if a user has selected to utilize the functionality of embodiments when importing a CAD file into a PLM platform. From step 102, if the answer is "No" (i.e., the functionality of embodiments is not being utilized), then the method progresses to "End" 120, as there is no need to progress. If the answer at step 102 is "Yes" the method 100 moves to step 103 and determines if any custom rules are defined. If no custom rules are defined (i.e., the answer is "No" at step 103), then, the method progresses to step 104 where a hard-coded configuration mapping logic (i.e., a default configuration mapping logic) is utilized for importing the CAD model into the PLM system and, then, moves to "End" 120. If step 103 determines that custom rules are defined (i.e., the answer is "Yes") then, the method 100 moves to step 105 where sub-typing rules are applied.

To apply sub-typing rules, the method 100 first moves to step 106 and determines if the model is included in a sub-type. If the answer is "No" at step 106 (i.e., the model is not included in a sub-type) then, the method 100 moves to step 104 where a hard-coded configuration mapping logic is used and, then, moves to "End" 120. If the answer is "Yes" at step 106 (i.e., the model is included in a sub-type) then, the method 100 moves to step 107 so as to process configuration mapping rules for the subtype and, then, moves to step 108 to determine if the configuration is a single physical product or multiple physical products.

To continue, responsive to determining the configuration is a single physical product at step 108, the method 100 moves to step 111 to determine which configuration is the single physical product. In the method 100, the single physical product can be the active configuration, first configuration, or named configuration. In an embodiment, a user can select which configuration is the single physical product. According to an embodiment, the "active" configuration is the configuration which was active the last time the model was saved, the first configuration is the first configuration in a history list of all configurations, and the "named" configuration is a configuration with a specific name. If the single physical product is the active configuration, the method 100 moves to step 117 where the single physical product is processed as the active configuration and other configurations are processed as representations. If step 111 determines the single physical product is the first configuration, the method 100 moves to step 118 where the single physical product is processed as the first configuration and other configurations are processed as representations. If step 111 determines that the single physical product is a named configuration, the method 100 moves to step 115 and determines if the named configuration is available. If the named configuration is available (yes at step 115), the method 100 moves to step 119 where the named configuration is processed as a physical product and other configurations are processed as representations. After the processing at each of steps 117, 118, and 119, the method 100 moves to step 120 and ends. Returning to step 115, if the named configuration is not available (i.e., the answer is "No"), the method moves to step 116 where a fallback method is used. To continue, the method 100 moves to step 113 where a fallback method is selected. From step 113, the selected fallback method can either be: a named configuration, in which case the method moves to step 115; a first configuration, in which case the method moves to step 118; or an active configuration, in which case the method moves to step 117.

Returning to step 108, alternatively, if at step 108 the method 100 determines the configuration is multiple physical products, the method moves to step 109 to process the configuration using multiple physical product mapping rules (for example, mapping all part numbers beginning with "98" or 99" as multiple physical products). Processing the configuration in accordance with the multiple physical product mapping rules includes determining at step 110 if the mapping rules result in at least one physical product. If at step 110 it is determined that the mapping will result in at least one physical product (i.e., yes at step 110), then the method 100 moves to step 114 where the configuration is mapped to physical products and representations in accordance with the multiple physical product mapping rules from step 109, and after step 114, the method 100 ends 120. If, at step 110, it is determined that the mapping will not result in at least on physical product (i.e., the answer is no), then the method moves to step 112 and uses a fallback method to designate a physical product. The fallback method is a default decision on which configuration to map as a physical product. From step 112, the method 100 moves to step 113, selecting a fallback method, and the method proceeds from step 113 as described above. In an embodiment, the fallback method can be selected at step 113, e.g., by a user through an interface, or may be automatically selected, e.g., via execution of programmed logic.

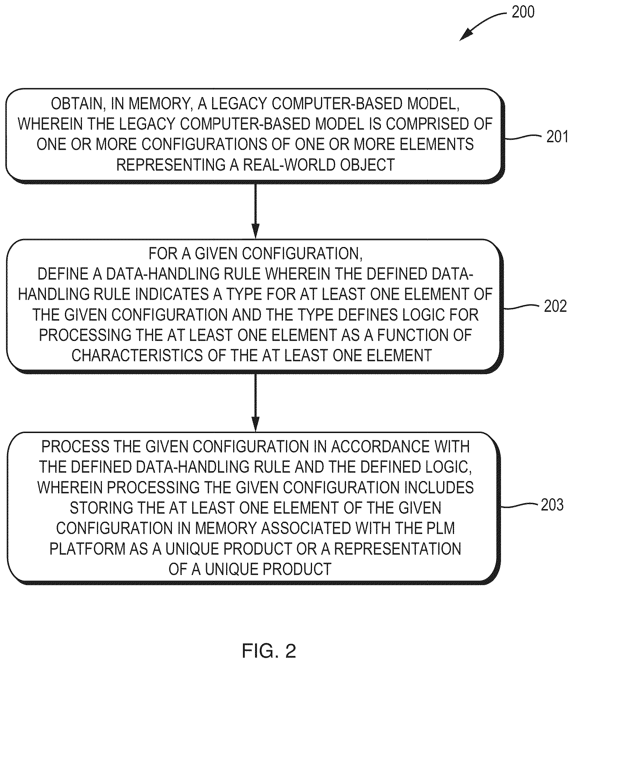

FIG. 2 is a flow diagram of a computer-implemented method 200 for storing a legacy computer-based model in a PLM platform, according to an embodiment. It is noted that while the method 200 is described as providing functionality for storing a legacy computer-based model in a PLM platform, embodiments of the method 200 are not limited to operating in the foregoing context and, instead, embodiments of the method 200 can be implemented for any software/program where configuration management is desired, e.g., in a program that cannot handle the configuration of a model being imported to the program.

The method 200 begins at step 201 by obtaining in memory of a processor (implementing the method), a legacy computer-based model, wherein the legacy computer-based model includes one or more configurations of one or more elements representing a real-world object. In embodiments, the computer-based model can be automatically obtained at step 201 or obtained responsive to user input. Further, in embodiments, the computer-based model can be obtained from any source, e.g., memory, that can be accessed via a computing device implementing the method 200. To continue, at step 202, for a given configuration, the method 200 defines 202 a data-handling rule. Defining a data-handling rule at step 202 may include selecting and/or associating an existing data-handling rule to be used with the given configuration or creating a new, e.g., user created, data handling rule to be used with the given configuration. The defined data-handling rule indicates a type for at least one element of the configuration, and the type defines logic for processing the at least one element as a function of characteristics of the at least one element. To illustrate step 202, in an example embodiment, a user may define a data handling rule for all parts which are of a "fastener" type. For example, such a rule may indicate that for fastener type parts with part numbers beginning with, for example, the letter "A," e.g., "A100" (where part number is a characteristic), the fasteners are stored as unique products, and for fastener type parts with part numbers beginning with, for example, the letter "B," e.g., "B100," the fasteners are stored as representations of a unique product. By being able to identify a plurality of similar parts to be processed with the same type logic, this prevents the user from having to duplicate efforts for every object of the same type. Additionally, this allows the user to edit the type logic in one location. In turn, at step 203, the given configuration is processed in accordance with the defined data-handling rule and the defined logic. Processing the configuration at step 203 includes storing the at least one element of the configuration in memory associated with the PLM platform as a unique product or a representation of a unique product. To illustrate step 203, considering the foregoing example, at step 203, a fastener of the given configuration is identified, and the foregoing rule is applied based on the part number of the fastener. Specifically, if, for instance, a fastener has part number beginning with "A80," the fastener is stored as a unique product, but if a fastener has part number beginning with "B80," the fastener is stored as a representation of a unique product.

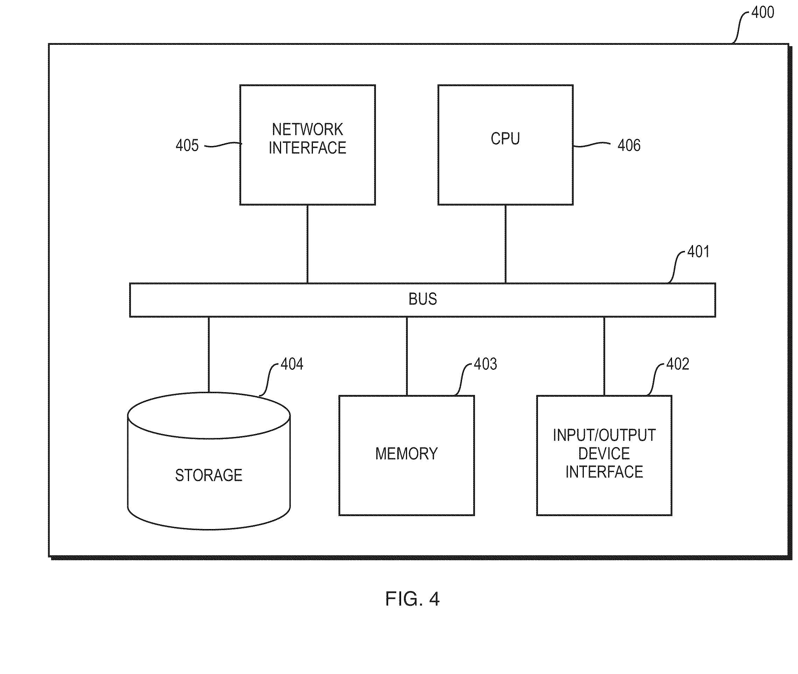

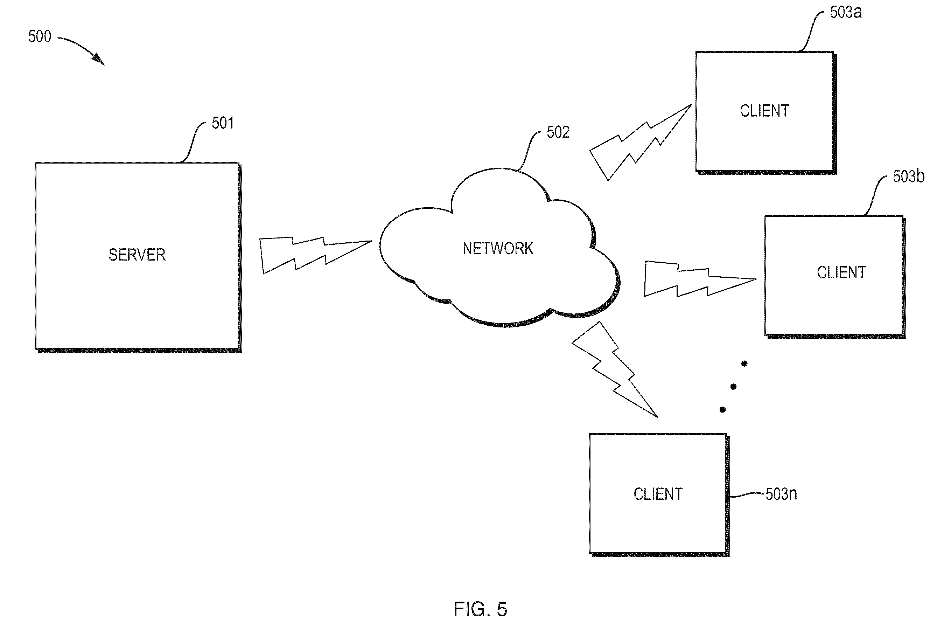

The method 200 is computer implemented and, as such, the functionality and effective operations, e.g., the steps 201-203, can be automatically implemented by one or more digital processors. Moreover, the method 200 can be implemented using any computer device or combination of computing devices known in the art. Amongst other examples, the method 200 can be implemented using the computer system 400 described herein below in relation to FIG. 4 and the computer network environment 500 described herein below in relation to FIG. 5.

Further, the method 200 can be implemented in a Platform as a Service (PaaS) environment. Dassault Systemes' 3DEXPERIENCE^{®} platform is described herein as but one example of an environment in which embodiments, e.g., method 200, can be implemented.

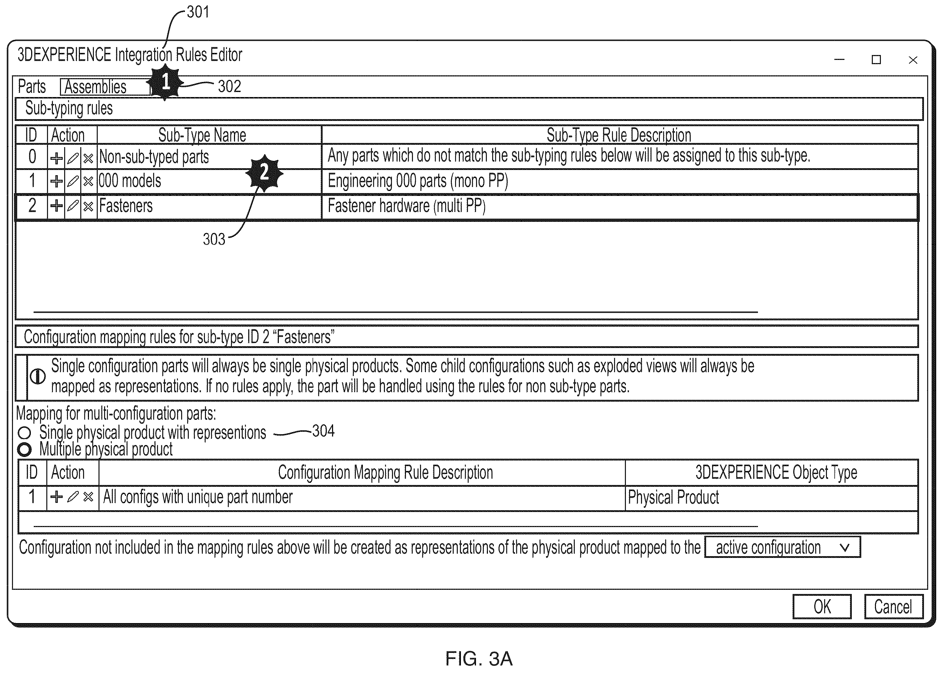

In an embodiment of the method 200, defining the data-handling rule at step 202 includes receiving, from a user, an indication of the type for the at least one element of the given configuration. In another embodiment, defining the data-handling rule at step 202 includes receiving, from a user, an indication of the logic for processing the at least one element, wherein the indication of the logic dictates, based on the characteristics of the CAD file, if the at least one element is stored as a unique product or a representation of a unique product. According to an embodiment, example characteristics include the configuration settings of the CAD file which may determine how to map each configuration. Configuration settings may include, the configuration name, the configuration description, configuration specific properties (i.e., user defined metadata fields) such as properties of the materials (i.e., steel), a configuration setting indicating how a part is treated within a bill of materials (BOM) (i.e., whether the part is treated as a unique part or the same as the parent part within the BOM), and whether a configuration is an active configuration, a named configuration, or a first configuration. According to an embodiment, configuration name and configuration description are based on string comparison, configuration setting indicating how a part is treated within a BOM is based on pre-defined options, and whether a configuration is the active, named, or first configuration is based on a yes/no type of option. Further, in embodiments of the method 200, rules may be defined utilizing the interfaces described hereinbelow in relation to FIGs. 3A-C.

In another embodiment of the method 200, processing the given configuration in accordance with the defined data-handling rule and the defined logic at step 202 includes, for the at least one element of the given configuration, identifying the type for the at least one element based on the defined data-handling rule and, based on the identified type, determining the defined logic for processing the at least one element as a function of characteristics. Such an embodiment identifies given characteristics of the at least one element and, based on the determined defined logic and the identified given characteristics, stores the at least one element in the memory associated with the PLM platform as a unique product or a representation of a unique product.

According to an embodiment, the one or more elements representing the real-world object include at least one individual component or an assembly of components of the one or more configurations.

In another embodiment of the method 200, processing the given configuration in accordance with the defined data-handling rule and the defined logic at step 203 includes identifying a given element of the given configuration, wherein the defined data-handling rule, and the defined logic does not indicate whether the given element should be stored as a unique product or a representation of a unique product. Responsive to identifying the given element, such an embodiment stores the given element as a unique product or a representation of a unique product in accordance with a default data-handling rule. Further, embodiments may also utilize a contingency provision for configurations which are not categorized by any rule.

In another embodiment, at least one configuration of the one or more configurations is one of a defeature configuration or graphical representation configuration, e.g., a speedpak configuration. In such an embodiment, a parent configuration of the at least one configuration is identified and an element of the at least one configuration is stored in the memory as a representation of a unique product corresponding to the identified parent configuration.

In an embodiment, if a configuration is a graphical representation configuration or defeature configuration, the configuration is converted to a representation against its parent configuration. No rule is applied to such configurations even though the user has added a specific rule to handle these special types of configurations. Such an embodiment goes through configuration mapping rules, e.g., all stored rules, and collects which configurations need to be physical products and representations. For example, a hypothetical "Config_A" is categorized as a representation by a hypothetical "Rule_1." However, a hypothetical "Rule_5" is supposed to make "Config_A" a physical product by selection of 3DExperience Object Type as "Physical Product," then "Config_A" is converted to a physical product ignoring "Rule_1." In this example, designating the configuration as a physical product takes priority.

By some rule definition, according to an embodiment, a hypothetical "Config_B" is supposed to be a representation of a "Config_C" (where "Config_C" is supposed to be a physical product), but "Config_C" itself is already categorized as a representation of a physical product corresponding to "Config_A," then "Config_B" is also categorized as a representation of a physical product corresponding to "Config_A."

In an embodiment, when mapping a given configuration ("Config_A") as a "representation" of a parent physical product, where the user has selected to use the "active configuration" ("Config_B") as the parent physical product, and the "Config _B" is itself a representation, "Config_A" is then mapped as a representation of the parent product of Config_B. This mapping logic may be herein referred to as hierarchical mapping.

In an embodiment, if the selection for mapping the configuration is selected to be a "representation" and the configuration is selected to use the "configuration named," for example, "qwerty," as the parent physical product, or use the "first configuration" if that configuration name (i.e., "qwerty") does not exist - then, if the named configuration exists and is identified as a representation, the conversion (i.e., saving a legacy CAD model into a PLM platform) is handled in the same way as the hierarchical mapping embodiment. If the named configuration does not exist, but if the active / first configurations are identified as a representation, the conversion is handled the same as the hierarchical mapping embodiment.

Embodiments may utilize a contingency provision for configurations which cannot be categorized by any rule. According to the contingency provisions, in case of such un-categorized configurations, the configuration not included in the mapping rules will be created as representations of the physical product mapped to either the named configuration, the active configuration, or the first configuration. If the named configuration exists and is identified as a representation, the conversion (i.e., storing the CAD model in a PLM platform) is handled the same as the hierarchical mapping embodiment. If the named configuration does not exist, but if the active / first configurations are identified as a representation, the conversion is handled the same as the hierarchical mapping embodiment.

According to an embodiment, in the case of a "Linked to Parent" i.e., derived configurations, such configurations will typically be representations of either physical products corresponding to their parent configurations or handled in the same way as the hierarchical mapping embodiment, unless one of the rules identifies it as a physical product by selection of 3DEX Object Type as `Physical Product'(i.e., user exclusively wants to make it a physical product and an embodiment will not restrict it).

FIG. 3A shows a GUI 301 that may be utilized in embodiments. Specifically, the GUI 301 is an example integration rules editor window. The integration rules editor 301 contains tabs 302 which are used to switch between Parts and Assembly user-interfaces. In each interface sub-typing rules can be defined in the Sub-Type Name column, for example, Fasteners 303. Users may add rows to sub-type parts or assemblies with different configuration mapping rules applying to each sub-type. The lower pane 304 defines configuration mapping rules for the selected sub-type row. Users may choose between single and multiple physical products.

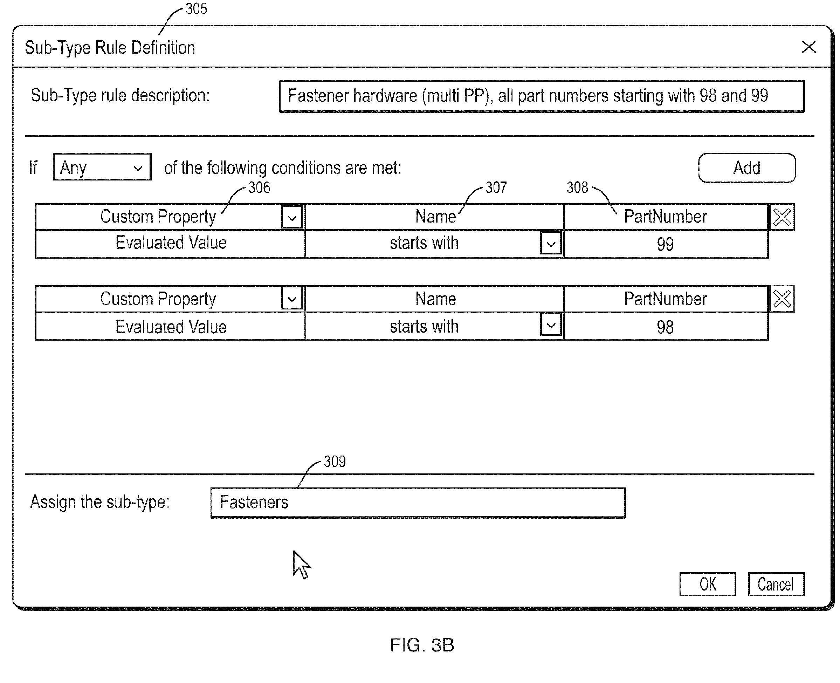

FIG. 3B shows a sub-type rule definition GUI 305. According to an embodiment, the sub-type rule GUI 305 allows users to define how a particular sub-type is to be processed. For example, a sub-type rule may be for all "Fastener hardware (multi PP), all part numbers starting with 98 and 99." In such an example, a user will then add conditions to this rule, such as the Custom Property 306, the Name 307, and the Part Number 308. This assigns the rule to the "sub-type" 309. In this example the sub-type 309 is "Fasteners."

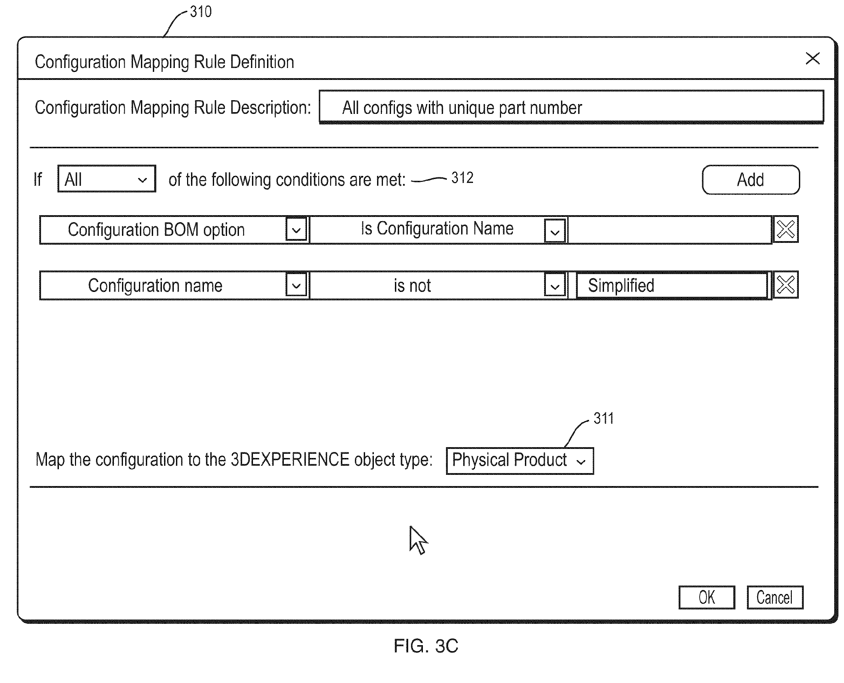

FIG. 3C shows a configuration mapping rule editor GUI 310 for the above referenced embodiment. The GUI 310 allows users to map a plurality of configurations as either representations or physical products at once. For example, in FIG. 3C it is described as "all configurations with unique part number," will be mapped as physical products 311. This can be set based on user defined conditions 312 in the GUI. FIGs. 3B - 3C show one example of sub-type rule definition, a person of ordinary skill in the art would understand that this can be reconfigured for a plurality of sub-type rule definitions.

FIG. 4 is a simplified block diagram of a computer-based system 400 that may be used to implement any embodiments described herein. The system 400 comprises a bus 401. The bus 401 serves as an interconnect between the various components of the system 400. Connected to the bus 401 is an input/output device interface 402 for connecting various input and output devices such as a keyboard, mouse, display, speakers, etc. to the system 400. A central processing unit (CPU) 406 is connected to the bus 401 and provides for the execution of computer instructions implementing embodiments, e.g., method 200. Memory 403 provides volatile storage for data used for carrying out computer instructions implementing embodiments described herein. Storage 404 provides non-volatile storage for software instructions, such as an operating system (not shown) and embodiment configurations, etc. The system 400 also comprises a network interface 405 for connecting to any variety of networks known in the art, including wide area networks (WANs) and local area networks (LANs).

It should be understood that the example embodiments described herein may be implemented in many different ways. In some instances, the various methods and machines described herein may each be implemented by a physical, virtual, or hybrid general purpose computer, such as the computer system 400, or a computer network environment such as the computer environment 500, described herein below in relation to FIG. 5. The computer system 400 may be transformed into the machines that execute the methods described herein, for example, by loading software instructions into either memory 403 or non-volatile storage 404 for execution by the CPU 406. One of ordinary skill in the art should further understand that the system 400 and its various components may be configured to carry out any embodiments or combination of embodiments described herein. Further, the system 400 may implement the various embodiments described herein utilizing any combination of hardware, software, and firmware modules operatively coupled, internally, or externally, to the system 400.

FIG. 5 illustrates a computer network environment 500 in which an embodiment of the present invention may be implemented. In the computer network environment 500, the server 501 is linked through the communications network 502 to the clients 503a-n. The environment 500 may be used to allow the clients 503a-n, alone or in combination with the server 501, to execute any of the methods described herein. For non-limiting example, computer network environment 500 provides cloud computing embodiments, software as a service (SAAS) embodiments, and the like.

Embodiments or aspects thereof may be implemented in the form of hardware, firmware, or software. If implemented in software, the software may be stored on any non-transient computer readable medium that is configured to enable a processor to load the software or subsets of instructions thereof. The processor then executes the instructions and is configured to operate or cause an apparatus to operate in a manner as described herein.

Further, firmware, software, routines, or instructions may be described herein as performing certain actions and/or functions of the data processors. However, it should be appreciated that such descriptions contained herein are merely for convenience and that such actions in fact result from computing devices, processors, controllers, or other devices executing the firmware, software, routines, instructions, etc.

It should be understood that the flow diagrams, block diagrams, and network diagrams may include more or fewer elements, be arranged differently, or be represented differently. But it further should be understood that certain implementations may dictate the block and network diagrams and the number of block and network diagrams illustrating the execution of the embodiments be implemented in a particular way.

Accordingly, further embodiments may also be implemented in a variety of computer architectures, physical, virtual, cloud computers, and/or some combination thereof, and thus, the data processors described herein are intended for purposes of illustration only and not as a limitation of the embodiments.

While example embodiments have been particularly shown and described, it will be understood by those skilled in the art that various changes in form and details may be made therein without departing from the scope of the embodiments encompassed by the appended claims.

For example, the foregoing description and details of embodiments in the figures reference Applicant-Assignee (Dassault Systemes Americas Corporation) and Dassault Systemes, tools and platforms, for purposes of illustration and not limitation. Other similar tools and platforms are suitable.

The teachings of all patents, published applications, and references cited herein are incorporated by reference in their entirety.

## Claims

1. A computer-implemented method for storing a legacy computer-based model in a product lifecycle management (PLM) platform, the method comprising, by a processor:
obtaining, in memory of the processor, a legacy computer-based model, wherein the legacy computer-based model is comprised of one or more configurations of one or more elements representing a real-world object;
for a given configuration:
defining a data-handling rule wherein the defined data-handling rule indicates a type for at least one element of the given configuration and the type defines logic for processing the at least one element as a function of characteristics of the at least one element; and
processing the given configuration in accordance with the defined data-handling rule and the defined logic, wherein processing the given configuration includes storing the at least one element of the given configuration in memory associated with the PLM platform as a unique product or a representation of a unique product.

2. The method of Claim 1, wherein defining the data-handling rule comprises:
receiving, from a user, an indication of the type for the at least one element of the given configuration.

3. The method of Claim 1, wherein defining the data-handling rule comprises:
receiving, from a user, an indication of the logic for processing the at least one element, wherein the indication of the logic dictates, based on the characteristics, if the at least one element is stored as a unique product or a representation of a unique product.

4. The method of Claim 1, wherein processing the given configuration in accordance with the defined data-handling rule and the defined logic comprises, for the at least one element of the given configuration:
based on the defined data-handling rule, identifying the type for the at least one element;
based on the identified type, determining the defined logic for processing the at least one element as a function of characteristics;
identifying given characteristics of the at least one element; and
based on the determined defined logic and the identified given characteristics, storing the at least one element in the memory associated with the PLM platform as a unique product or a representation of a unique product.

5. The method of Claim 1, wherein the one or more elements representing the real-world object comprises:
at least one individual component or an assembly of components of the one or more configurations.

6. The method of Claim 1, wherein processing the given configuration in accordance with the defined data-handling rule and the defined logic comprises:
identifying a given element of the given configuration, wherein the defined data-handling rule and the defined logic does not indicate whether the given element should be stored as a unique product or a representation of a unique product; and
responsive to identifying the given element, storing the given element as a unique product or a representation of a unique product in accordance with a default data-handling rule.

7. The method of Claim 1, wherein at least one configuration of the one or more configurations is one of a defeature configuration or graphical representation configuration.

8. The method of Claim 7 further comprising:
identifying a parent configuration of the at least one configuration; and
storing an element of the at least one configuration in the memory as a representation of a unique product corresponding to the identified parent configuration.

9. A computer program for storing a legacy computer-based model in a product lifecycle management (PLM) platform, comprising instructions which, when executed by a computer system, cause the computer system to perform the method according to any one of Claims 1 to 8.

10. A system for storing a legacy computer-based model in a product lifecycle management (PLM) platform, the system comprising:
a processor; and
a memory having recorded thereon the computer program of Claim 9.

11. The system of Claim 10, the computer program being executed by a server in communication across a network with one or more client.
